# EUROPEAN PATENT SPECIFICATION

(11) **EP 1 912 483 B1**
(45) Date of publication and mention of the grant of the patent: **05.09.2012**
(21) Application number: 06781987.0
(22) Date of filing: 31.07.2006
(51) Int. Cl.: H05H 1/24, C01B 31/02, C23C 14/06, C23C 16/509, H01J 37/32, H05H 1/46

(54) **PLASMA GENERATOR AND FILM FORMING METHOD EMPLOYING SAME**
PLASMAGENERATOR UND DIESEN VERWENDENDES FILMBILDUNGSVERFAHREN
GENERATEUR DE PLASMA ET PROCEDE DE FABRICATION DE PELLICULE L' EMPLOYANT

(30) Priority: 02.08.2005 JP 2005224355; 02.08.2005 JP 2005224356; 02.08.2005 JP 2005224357; 28.10.2005 JP 2005313867
(43) Date of publication of application: 16.04.2008
(73) Proprietor: PURERON JAPAN CO. LTD., Iwaki-shi Fukushima (JP)
(72) Inventor: JIANG, Nan, c/o Dialight Japan Co., Ltd, Osaka 563-0043 (JP); WANG, Hong-Xing, c/o Dialight Japan Co., Ltd, Osaka 563-0043 (JP); HIRAKI, Akio, c/o Dialight Japan Co., Ltd, Osaka 563-0043 (JP); HABA, Masanori, c/o Dialight Japan Co., Ltd, Osaka 563-0043 (JP)
(74) Representative: Wagner, Bernhard Peter
(86) International application number: PCT/JP2006/315109
(87) International publication number: WO 2007/015445

(56) References cited:
- WO-A-02/19379
- JP-A- 62 136 572
- JP-A- 2001 043 997
- JP-A- 2004 281 232
- JP-A- 2005 026 063
- JP-A- 2005 129 323
- US-A- 5 300 951
- US-A- 5 711 814
- BARDOS L.: 'Radio Frequency Hollow Cathodes for The Plasma Processing Technology' SURFACE AND COATINGS TECHNOLOGY vol. 86-87, 01 December 1996, pages 648 - 656, XP003003296
- LIU B. ET AL.: 'Inner Surface Coating of TiN by The Grid-Enhanced Plasma Source Ion Implantation Technique' J. VAC. SCI. TECHNOL. A vol. 19, no. 6, November 2001, pages 2958 - 2962, XP012005901

## Description

### FIELD OF THE INVENTION

The present invention relates to a plasma generating device for generating plasma by applying a voltage to an electrode placed in the vacuum inside of the device and a film deposition method in which the plasma generating device is used.

### BACKGROUND OF THE INVENTION

The plasma can be used for the formation of a thin film in the manufacturing of a semiconductor, a display element, a magnetic recording element, an abrasion-resistant element and the like.

In the case where the film is formed on a surface of a substrate which is long in a direction such as wire, a plasma generating device capable of generating long plasma is necessary.

Examples of the film deposition using the plasma include PVD (Physical Vapor Deposition) and CVD (Chemical Vapor Deposition). The respective film deposition methods need different film deposition devices.

| | |
|---|---|
| Patent Document 1: | No. 2004-216246 of the Japanese Patent Applications Laid-Open |
| Patent Document 2: | No. 2980058 of the Japanese Patent Documents |
| Patent Document 3: | No. H10-203896 of the Japanese Patent Applications Laid-Open |
| Patent Document 4: | No. 2004-190082 of the Japanese Patent Applications Laid-Open |

US 5,300,951 A describes a member coated with ceramic material and a method of manufacturing the same. Herein, a cylindrical reaction chamber is supported such that the axial direction of the chamber extends vertically. The chamber is electrically insulated from the earth by means of insulating member. The chamber is evacuated by a mechanical booster pump. Various source gases can be supplied to the chamber, through a gas supply port. A cylindrical electrode is coaxially arranged in the chamber and is kept at the same potential as that thereof. A plurality of gas apertures are formed in the electrode. Gas supplied to the chamber through a port is supplied substantially uniformly to the center of the chamber, by means of the gas apertures in the electrode. As a support for a ceramic layer, a cylindrical base material is situated at the center of the chamber such that the axial direction of the material extends vertically. A heater, is inserted in the center of the cylindrical base material along its longitudinal direction. The heater is connected to a power source. The base material and the support member are connected to a RF power source via a matching circuit. RF power is applied to the base material or to the chamber, so that a plasma discharge occurs therebetween. The treatment of the base material surface and the ceramic coating are performed by a plasma CVD. However, sputtering, ion plating, thermal CVD, or photo CVD may be used in place of plasma CVD. In addition, the plasma generation power is not limited to RF power but can be extended to DC power. In this case, the matching circuit can be eliminated. After a carbonization process of the cylindrical base material, a ceramic material is formed on the carbonized surface of the base material to form a sliding shaft member for a laser scanner having an improved anti-wear property and improved sliding characteristics.

WO 02/19379 A1 describes a device and a process for producing DC glow discharge. Herein, a conventional DC glow discharge device comprises a cold cathode emitting electrons by secondary emission created by ions striking the cathode. The electrons are accelerated by the electric field existing between the cathode and the anode. Herein, the anode area is extremely small as compared to the area of the cathode. A vacuum is created by pumping down the air inside a chamber containing the anode and the cathode with the help of diffusion pumps. After evacuating the chamber, a mixture of desired gases is introduced inside the chamber. Initiation of the plasma is done by increasing the pressure. The plasma can be initiated by thermoionic electron emission from a filament and making the plasma initiate at low pressures. It is possible to maintain a DC plasma having a significant density which can be utilized for plasma nitriding, plasma assisted chemical vapour deposition and the like, at low pressures by proper design of the anode-cathode areas and their positioning in the vacuum chamber.

US 5,711,814 A describes a method of and an apparatus for forming film with rotary electrode. Herein, a cylindrical electrode is employed as an electrode rotating about its rotation axis. For forming a thin film on a substrate, the rotary electrode is rotated so that an electrode surface of the electrode moves and passes by the substrate surface due to the rotation of the electrode. Thereby, a reaction gas is supplied into a gap between the substrate surface and the electrode surface. A high-frequency power is applied by a high-frequency source or a DC power is applied to the rotary electrode thereby- generating a plasma between the substrate surface and the electrode surface, for forming a thin film by chemical, reaction of the reaction gas supplied into the plasma.

BARDOS L.: 'Radio Frequency. Hollow Cathodes for the Plasma Processing Technology' SURFACE AND COATINGS TECHNOLOGY vol. 86-87, 01 December 1996, pages 648-656, XP003003296, describes a radio frequency hollow cathode for the plasma processing technology. Herein, a hollow cathode discharge is generated by a radio frequency instead of a DC field. The pressure of gas inside the hollow cathode is almost independent on the reactor pressure, which allows to generate discharge at high collision frequency and transport it into the low pressure reactor. The discharge forced out from the hollow cathode forms a decaying plasma channel with extraordinary properties. Gas metastables excited inside the cathode can act in selected gas mixtures as a source of additional heat, thereby enhancing thermionic electron emission and ionization of the gas. An arc regime can be started from the glow discharge simply by increasing the r.f. power. Hollow cathode arc in the cathode metal vapor can be sustained even without working gas. Examples of utilization of hollow cathodes in the film deposition and dry etching technology are presented. Small size cylindrical r.f. cathodes allow special applications inside narrow tubes. Linear arc discharge (LAD) produced by r.f. hollow cathode with magnetic focusing promises new applications either with or even instead of magnetrons.

JP 62136572 A describes the formation of a thin film by plasma CVD method. Herein, a cylindrical substrate stacked with extending members at both ends in the axial direction is placed on a rotatable substrate support and is held at about the same height as the height of a cylindrical electrode enclosing the substrate. The extending members and the substrate or the inside part thereof are maintained at the same potential by inserting a conductive cylinder into the substrate or by other means. A glow discharge is then induced between the electrode and the substrate to decompose the gaseous material introduced between the electrode and the substrate by which the thin film is formed on the substrate.

### DISCLOSURE OF THE INVENTION

### PROBLEM TO BE SOLVED BY THE INVENTION

It is an object of the present invention to provide a plasma generating device and a method for manufacturing a cold cathode electron source for a field emission lamp having a superior electron emitting characteristic.

A further object of the present invention is to provide a plasma generating device capable of forming a film in a simplified and inexpensive manner on a target having a long length and adaptable to different film deposition methods, and a film deposition method in which the plasma generating device is used.

This object is solved by a plasma generating device according to claim 1 and a method according to claim 5. Further advantages, refinements and embodiments of the invention are described in the respective sub-claims.

### MEANS FOR SOLVING THE PROBLEM

1) A plasma generating device according to the present invention is described in claim 1.

The cylindrical electrode preferably comprises a peripheral wall having at least a coil shape, a net shape, a barrier shape or a basket shape.

The cylindrical electrode is preferably open at each end and linearly extends towards each end so as to allow a film deposition target having a plate shape or a wire shape to be placed inside thereof.

The cylindrical electrode is preferably formed from metal.

The cylindrical electrode is preferably formed from solid carbon.

The cylindrical electrode preferably has a circular sectional surface.

The cylindrical electrode preferably has a polygonal sectional surface.

Wherein the cylindrical electrode is used, the cylindrical electrode can be formed into a long cylindrical shape in compliance with a film deposition target in the case where the target has such a long shape as the plate shape or the wire shape, and the film deposition target can be placed inside the device for the film deposition.

Accordingly, in the case where plasma having a long length is necessary in order to form the film on the film deposition target, the cylindrical electrode can be extended to have a long length so that the long plasma can be generated. In order to generate the long plasma, it is only necessary to extend the length of the cylindrical electrode. As a result, cost for generating the long plasma can be controlled.

According to the present invention, wherein both ends of the cylindrical electrode are open and the film deposition target is inserted into the cylindrical-electrode, in the case where the film deposition target is long like a wire, the cylindrical electrode and the film deposition target can be moved in relation to each other, and the film can be inexpensively formed on the long film deposition target, eliminating the necessity of extending the length of the plasma.

According to the plasma generating device of the present invention, one device can be applied to a plurality of film deposition methods such as PVD, reactive PVD, and CVD by controlling the pressure and selecting a type of gas.

One end or both ends of the cylindrical electrode may be open or closed.

The shape of the film deposition target is not particularly limited.

Examples of the shape of the film deposition target include a plate shape, wire shape and the like.

The sectional shape of the film deposition target is not particularly limited.

Examples of the shape of the film deposition target include a circular shape, a semi circular shape, an elliptical shape, a polygonal shape and the like.

The shape of the cylindrical electrode is not particularly limited.

In the case where the peripheral wall of the cylindrical electrode has a coil shape or a net shape, the plasma can be generated with a desired density through the adjustment of a spiral diameter and a spiral pitch. Further, a thermal expansion of the cylindrical electrode at the time when the plasma is generated can be efficiently absorbed and a stress resulting from the thermal expansion can be alleviated so that a life of the cylindrical electrode can be improved.

In the case where the peripheral wall of the cylindrical electrode has a barrier shape or a basket shape, the plasma can be evenly and densely generated between the cylindrical electrode and the film deposition target having a wire shape or a plate shape.

2) A plasma generating method according to the present invention, in which the plasma generating device recited in 1) is used, comprises a first step for placing the film deposition target inside the cylindrical electrode, a second step for reducing an internal pressure of the cylindrical electrode, a third step for introducing gas into the cylindrical electrode, and a fourth step for applying a direct-current negative voltage to the cylindrical electrode.

The plasma generating method preferably further comprises a fifth step for applying a bias voltage for controlling a film deposition speed to the film deposition target.

The plasma generating method preferably further comprises a sixth step for applying a bias voltage for controlling a film quality to the film deposition target.

### EFFECT OF THE INVENTION

According to the present invention, the long plasma can be easily and inexpensively generated. At the same time, in the present invention, one plasma generating device can be applied to a plurality of film deposition methods by controlling pressure and selecting a type of gas.

### BRIEF DESCRIPTION OF THE DRAWINGS

Fig. 1 shows an example of a plasma generating device according to aspects of the present invention.
Fig. 2 shows an external appearance of the plasma generating device.
Fig. 3A shows a photograph of a state where the plasma is generated by the plasma generating device.
Fig. 3B shows a photograph of a state where the plasma is generated by the plasma generating device.
Fig. 4 shows a modified example of a cylindrical electrode.
Fig. 5 shows another example of the cylindrical electrode.
Fig. 6 shows still another example of the cylindrical electrode.
Fig. 7 shows a side view of a cathode having a wire shape on which a carbon film is formed.
Fig. 8 shows a sectional view of a field emission lamp provided with the wire-shape cathode shown in Fig. 7.
Fig. 9 shows another example of the plasma generating device.
Fig. 10 shows still another example of the plasma generating device.
Fig. 11 is a SEM photograph showing the film deposition by the plasma generating device.
Fig. 12 is a sectional view showing a film deposition structure by the plasma generating device.
Fig. 13 shows a sectional shape of a carbon film having a needle shape shown in Fig. 12.
Fig. 14 shows still another example of the plasma generating device.
Fig. 15 shows still another example of the plasma generating device.
Fig. 16 shows an embodiment of the plasma generating device of the present invention.
Fig. 17 shows still another example of the plasma generating device, according to a further aspect of the present invention.
Fig. 18 is a graph in which a voltage of a bias power supply is shown in a horizontal axis and a speed of film deposition on a surface of a conductive wire is shown in a vertical axis, in the plasma generating device shown in Fig. 17.
Fig. 19 is a graph in which the voltage of the bias power supply is shown in a horizontal axis and the quality of a film on the surface of the conductive wire is shown in a vertical axis, in the plasma generating device shown in Fig. 17.

### DESCRIPTION OF REFERENCE SYMBOLS

- 10: plasma generating device
- 20: cylindrical electrode
- 22: conductive wire (film deposition target).

### PREFERRED EMBODIMENT OF THE PRESENT INVENTION

Hereinafter, a plasma generating device is described referring to the drawings.

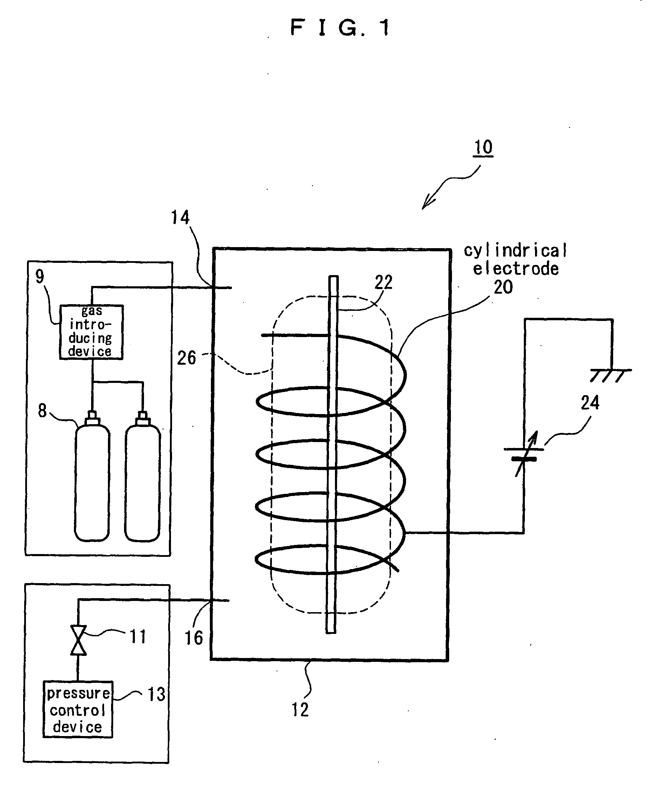

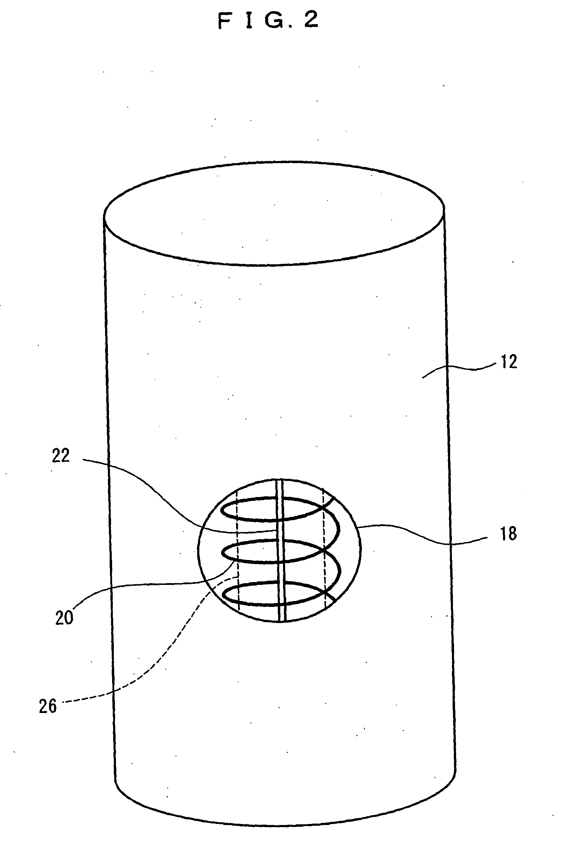

Fig. 1 shows a constitution of the plasma generating device, and Fig. 2 shows an external appearance of the plasma generating device. A plasma generating device 10 comprises a cylindrical vacuum chamber 12. The chamber 12 is conductive or electrically insulated. The chamber 12 comprises a gas introducing section 14 and a gas exhausting section 16. The chamber 12 comprises a visual-check window 18. A gas introducing device 9 is connected to the gas introducing section 14. The gas introducing device 9 selects gas corresponding to a type of film deposition method from a gas cylinder 8 and adjusts a pressure or a flow amount of the selected gas, and then, introduces the gas into the gas introducing section 14. The gas cylinder 8 can also be included in the gas introducing device. A pressure control device 13 is connected to the gas exhausting section 16 via an exhaust control valve (vacuum valve) 11. The pressure inside the cylindrical vacuum chamber 12 can be controlled to keep it in the range of 10 Pa to 10,000 Pa depending on an opening degree of the exhaust control valve 11 under the control by the pressure control device 13.

The plasma generating gas is, for example, non-reactive gas such as argon or helium in the case where the plasma generating device 10 according to the present preferred embodiment is used as a PVD device. The plasma generating gas is, for example, reactive gas such as oxygen in the case where the plasma generating device 10
is used as a reactive PVD device, and, for example, carbon-based gas when used as a CVD device.

The internal pressure of the chamber 12 is appropriately set in the range of 10 Pa to 10,000 Pa. The internal pressure is set to, for example, at most 100 Pa in the case where the plasma generating device 10 is used as the PVD device or the reactive PVD device, and to, for example, at least 500 Pa when used as the CVD device.

A cylindrical electrode 20 is provided inside the chamber 12.

The cylindrical electrode 20 is formed in a coil shape.

A conductive wire 22, which is a film deposition target, is provided in an internal space of the cylindrical electrode 20. The cylindrical electrode 20 is linearly extended in one direction. The internal space of the cylindrical electrode 20 constitutes a space for generating long cylindrical plasma extended in one direction. The conductive wire 22 is provided in the internal space and has a long and thin shape.

An inner peripheral surface of the cylindrical electrode 20 and an outer peripheral surface of the conductive wire 22 face each other with a predetermined space therebetween in the direction they are extended. One-end side of the cylindrical electrode 20 is connected to a negative electrode of a voltage-variable direct-current power supply 24, and a direct-current negative voltage is applied thereto.

In the plasma generating device 10 thus constituted, the chamber 12 is depressurized by the pressure control device 13 and the plasma generating gas is introduced from the gas introducing section 14, and then, the negative voltage of the direct-current power supply 14 is applied to the cylindrical electrode 20. As a result, plasma 26 is generated in the internal space of the cylindrical electrode 20.

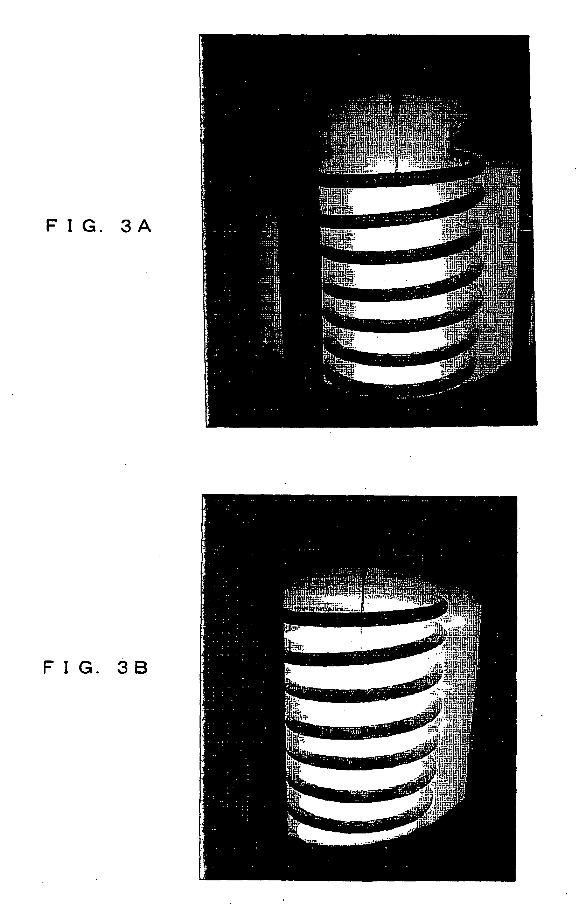

Figs. 3 show photographs of the generation of the plasma 26 in the internal space of the cylindrical electrode 20 in the plasma generating device 10. These photographs taken via the visual-check window 18 of the chamber 12 show the inside of the chamber 12. In the photograph of Fig. 3A, the voltage of the direct-current power supply 24 was 700 V, methane / hydrogen gas was selected as the gas to be introduced, and the pressure was 80 Pa. In the photograph of Fig. 3B, the voltage of the direct-current power supply 24 was 700 V, methane / hydrogen gas was selected, and the pressure was 170 Pa. A material of the cylindrical electrode 20 was SUS, and a material of the conductive wire 22 was nickel. Though the reference symbols cannot be shown in the photographs, the cylindrical electrode 20, wire 22 and plasma 26 in the chamber 12 can be clearly photographed via the visual-check window 18 from outside of the chamber 12.

A method of forming a film on a wire by the plasma generating device 10 is described below. The conductive wire 22 is placed inside of the cylindrical electrode 2. Both ends of the wire 22 may be connected to an alternate-current power supply 23 in order to heat the wire 22. The hydrogen gas and the methane gas are introduced through the gas introducing section 14.

When the internal pressure of the chamber 12 is reduced and the negative potential of the direct-current power supply 24 is applied to the cylindrical electrode 20, the plasma 26 is generated in the internal space of the cylindrical electrode 20, and the methane gas is thereby dissolved. As a result, a carbon film is formed on the surface of the wire 22.

In the photographs of Figs. 3, the conductive wire 22 is placed in the internal space of the cylindrical electrode 20 as a film deposition target. The carbon film could be formed on the surface of the conductive wire 22.

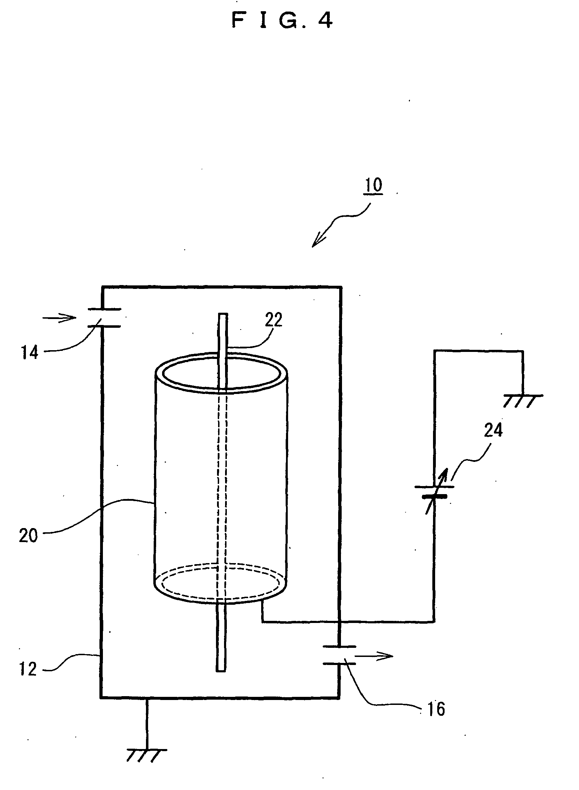

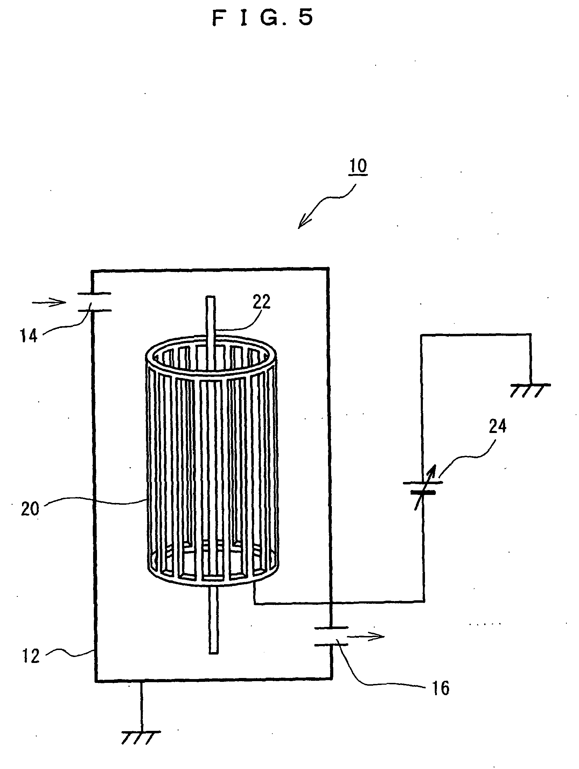

The cylindrical electrode 20 may have a closed cylindrical peripheral wall not provided with any opening as shown in Fig. 4, or a peripheral wall having a barrier shape circumferentially provided with a plurality of independent openings as shown in Fig. 5. A net shape may be adopted in place of the barrier shape.

The conductive wire 22 on which the carbon film is formed can be used as a cold cathode electron source. The cold cathode electron source can be incorporated into a field emission lamp. In the field emission lamp, electrons are emitted from the cold cathode electron source by the application of an electric field between the cold cathode electron source and an anode. The emitted electrons collide into phosphors and thereby excite the phosphors. As a result, light emission occurs.

Examples of the carbon film formed on the surface of the wire 22 include carbon nanotube, carbon nanowall film and needle-shape carbon film.

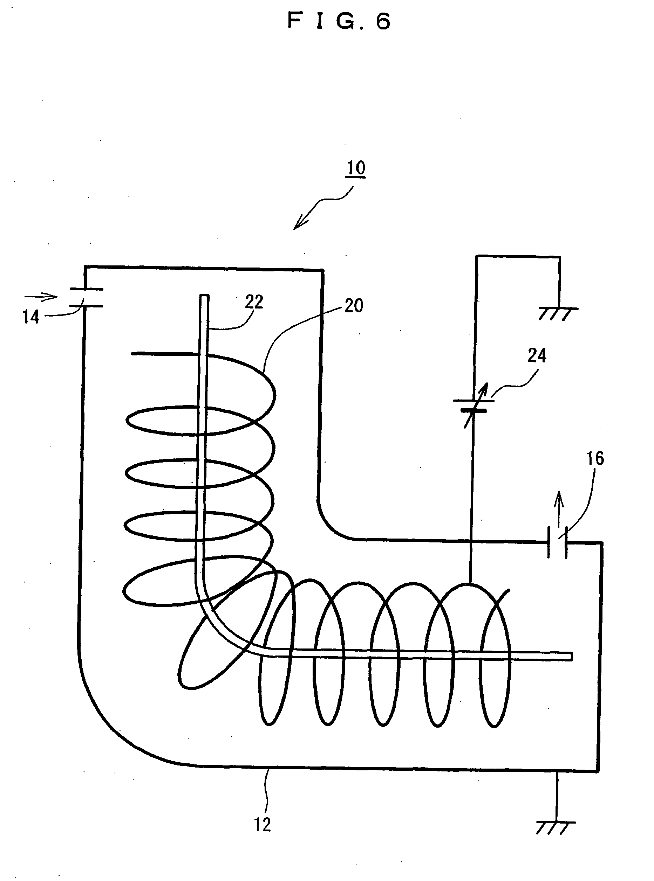

The carbon film can be formed on the surface of the conductive wire 22 when the cylindrical electrode 20 is bent, and the conductive wire 22 is also bent so as to correspond to the bent shape of the cylindrical electrode 20 and placed in the cylindrical electrode 20 as shown in Fig. 6.

As described, the cylindrical electrode 20 has such a length as approximately 2 m, the conductive wire 22 as long as, for example, 2 m is placed in the cylindrical electrode 20, and the long plasma 26 is generated along the shape of the internal space of the cylindrical electrode 20 in the internal space of the cylindrical electrode 20. As a result, the carbon film can be formed on the surface of the conductive wire 22.

As described, according to the plasma generating device, one device can be applied to film deposition methods such as PVD, reactive PVD, and CVD when the pressure is controlled and the type of gas is selected. More specifically, firstly, the present plasma generating device vacuum-controls the pressure to form such a low pressure as at most 100 Pa using the pressure control device, introduces a non-reactive gas such as argon or helium using the gas introducing device, and applies direct-current negative voltage to the cylindrical electrode using the voltage applying device. Accordingly, the gas is converted into plasma inside of the cylindrical electrode 20 by a high electrical field therein, and gas molecular ions are thereby generated. The generated ions collide into the cylindrical electrode, being attracted by the negative potential of the cylindrical electrode, and atoms are thereby thrown (sputtered) out of the cylindrical electrode. The film is formed on the surface of the film deposition target by the sputtered atoms. In other words, the plasma generating device according to the present invention can be used as the PVD device.

Secondly, the present plasma generating device controls the pressure to form such a low pressure as at most 100 Pa using the pressure control device, introduces a reactive gas such as oxygen using the gas introducing device, and applies the direct-current negative voltage to the cylindrical electrode using the voltage applying device. Accordingly, the plasma is generated inside the cylindrical electrode. The generated plasma sputters the materials constituting the cylindrical electrode such as iron and nickel, and the film made of an oxide such as that of iron and nickel is formed on the surface of the film deposition target placed in the cylindrical electrode. In other words, the plasma generating device according to the present invention can be used as the reactive PVD device.

Thirdly, the present plasma generating device controls the pressure to form such a high pressure as at least 500 Pa using the pressure control device, introduces, for example, a mixed gas including hydrogen gas and methane gas using the gas introducing device, and applies the direct-current negative voltage to the cylindrical electrode using the voltage applying device. Accordingly, the plasma is generated inside the cylindrical electrode. The carbon film is formed by the generated plasma on the surface of the film deposition target placed in the cylindrical electrode. In other words, the plasma generating device according to the present invention can be used as the plasma CVD device.

In the present plasma generating device, in the case where, for example, carbon-compound-based gas is introduced into the cylindrical electrode so that the carbon film is formed on the surface of the film deposition target such as a long wire or base material, the film deposition can be realized in such a simplified manner that the cylindrical electrode is extended in accordance with the length of the film deposition target and the film deposition target is placed inside the cylindrical electrode. As a result, cost for the film deposition can be reduced.

The present plasma generating device can be applied to the manufacturing of a cold cathode electron source of a field emission lamp. In the cold cathode electron source, a carbon film comprising a plurality of fine protrusions is formed on the surface of the conductive wire.

The present plasma generating device, wherein carbon-based gas is introduced, can be used as a direct-current plasma CVD device for forming a carbon film on a surface of a film deposition target.

The present plasma generating device, wherein etching gas is introduced, can be used as a direct-current plasma etching device. The present plasma generating device, wherein plating gas is introduced, can be used as a direct-current plasma plating device.

A single present plasma generating device provided with a CVD gas cylinder, an etching gas cylinder and a plating gas cylinder can generate plasma of at least three different types of film deposition.

In the plasma generating device 10 the cylindrical electrode 20 may be formed from solid carbon, in which case an entire electrode part of the cylindrical electrode 20 does not need to be formed from only solid carbon.

In the plasma generating device 10 , hydrogen plasma is generated when hydrogen gas is used as the introducing gas. The hydrogen ions in the plasma collide into the cylindrical electrode 20, which is the solid carbon source where the direct-current negative voltage is applied, at a high speed. Energy generated by the collision makes carbon pop out of the cylindrical electrode 20. The popped carbon, which is target particles, is chemically combined (CHx) with the hydrogen ions in the plasma to form a hydrocarbon compound, which collides into the film deposition target placed inside the cylindrical electrode 20, which is, for example, the conductive wire 22. The hydrogen pops out of the hydrocarbon compound which has collided into the conductive wire 22, while the carbon remains on the surface of the conductive wire 22 and is deposited thereon. As a result, the carbon film is formed on the surface of the conductive wire 22.

According to the plasma generating device 10, the carbon film can be formed on the surface of the conductive wire 22 without the introduction of any gas. Further, the carbon film can be formed on the surface of the conductive wire 22 by the plasma PVD when argon gas, for example, is used as the introducing gas.

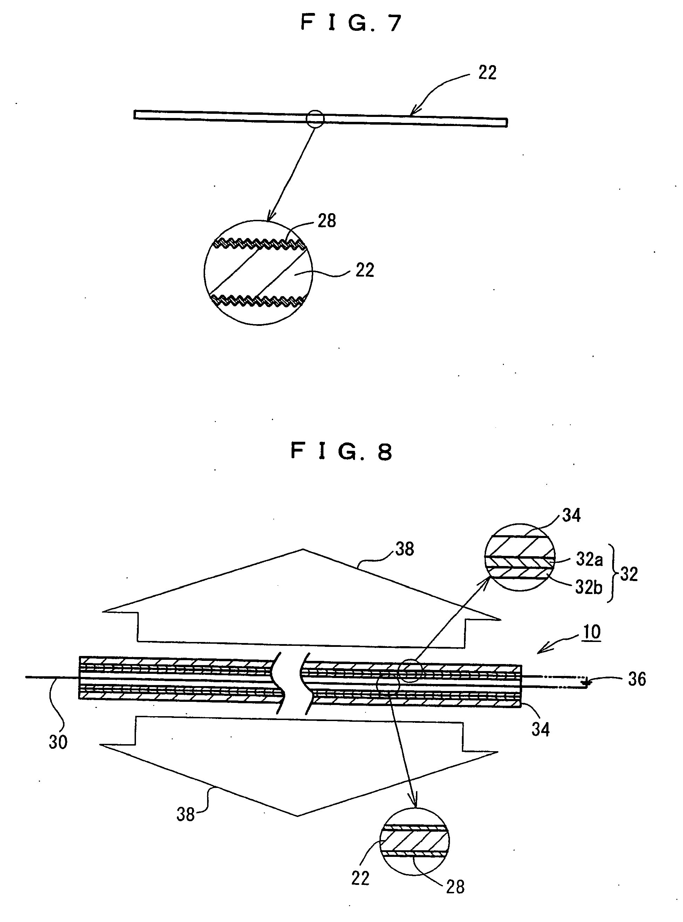

Fig. 8 shows a sectional structure of a field emission lamp provided with a wire 22, shown in Fig. 7, on which a carbon film 28 is formed as a wire-shape cathode 30.

As shown in Fig. 8, the field emission lamp comprises a wire-shape cathode 30 having a diameter of approximately 1 - 2mm and a length of 6cm to 2m inside a lamp tube 34 having a diameter of 2 - 25 mm and a length of 6 cm - 2 m. A phosphor-attached anode 32 is provided on an inner surface of the lamp tube 34. The phosphor-attached anode 32 comprises an anode 32a and a phosphor 32b. In a possible example of the field emission lamp shown in Fig. 8, gas which is excited by the collision of the electrons and generates ultraviolet ray is sealed into the lamp tube 34, and photoluminescence phosphor for converting the ultraviolet ray into visible light is provided on the inner peripheral surface of the lamp tube 34.

Apart from the foregoing, though not shown, the carbon film can be formed on the surface of the conductive wire in such a manner that a pair of rectangular electrodes is provided so as to face each other inside the chamber, the conductive wire is provided in one of the electrodes, hydrogen gas and carbon-based gas are introduced into the chamber, and the direct-current negative voltage is applied to between the electrodes so that the plasma is generated.

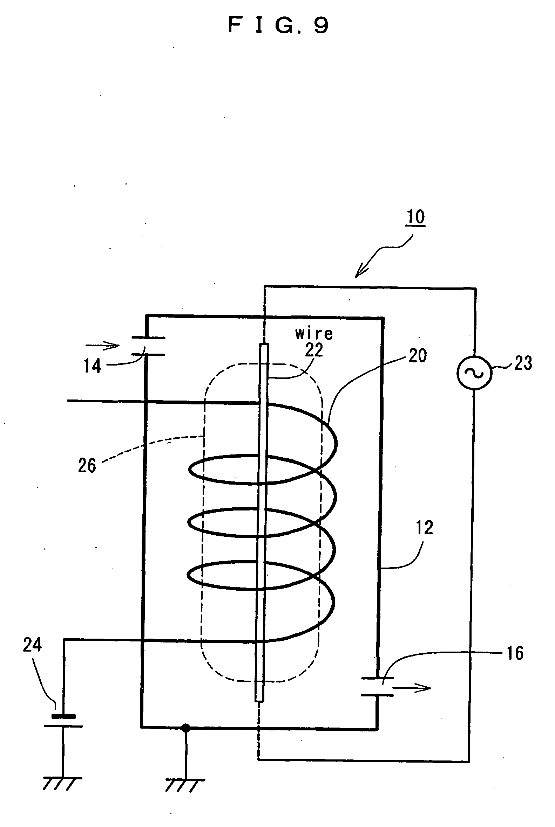

The conductive wire 22 may be heated by the alternate current source 23 as shown in Fig. 9. A wire diameter of the coil constituting the cylindrical electrode 20 is, for example, 2 mm to 25 mm, and an inter-wire space of the coil is, for example, 2 mm to 20 mm.

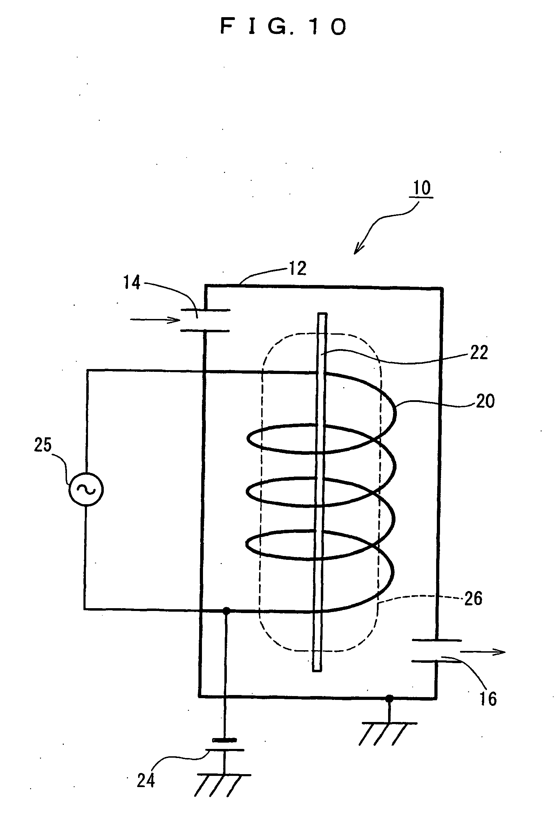

Fig. 10 shows still another example of the plasma generating device 10. In the present example, a high-frequency voltage is applied to both ends of the cylindrical electrode 20 from a high-frequency power supply 25. A power frequency of the high-frequency power supply 25 is, for example, 13.56 MHz, 4 MHz, 27.12 MHz, 40. 68 MHz or the like. A voltage in which the high-frequency voltage is superposed on the direct-current negative voltage (superposition voltage) is applied to the cylindrical electrode 20. A positive electrode of the direct-current power supply 24 is grounded. The wire diameter and the inter-wire space of the coil constituting the cylindrical electrode 20 are not particularly limited.

In the plasma generating device 10 thus constituted, when the chamber 12 is depressurized so that methane gas and hydrogen gas are introduced as the introducing gas from the gas introducing section 14, and the superposition voltage is applied to the cylindrical electrode 20, the plasma 26 is generated inside the cylindrical electrode 20. Then, the carbon film is formed by the plasma 26 on the surface of the conductive wire 22 placed inside the cylindrical electrode 20.

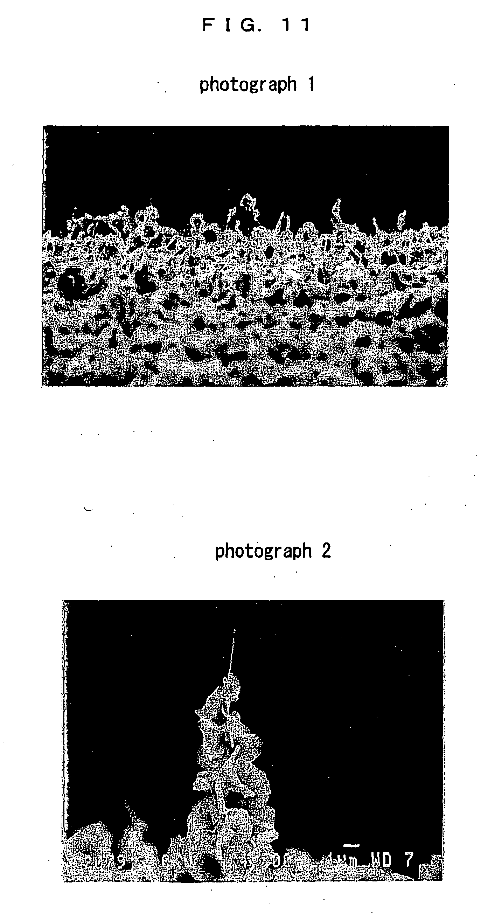

Fig. 11 shows SEM photographs 1 and 2 of the carbon film formed under the following conditions. The SEM photograph 2 is a close-up picture of the SEM photograph 1. In the SEM photograph 1, the applied voltage between the anode and cathode is 30 kV, and a magnification is 1,000 times. The magnification of the SEM photograph 2 is 4,300 times.

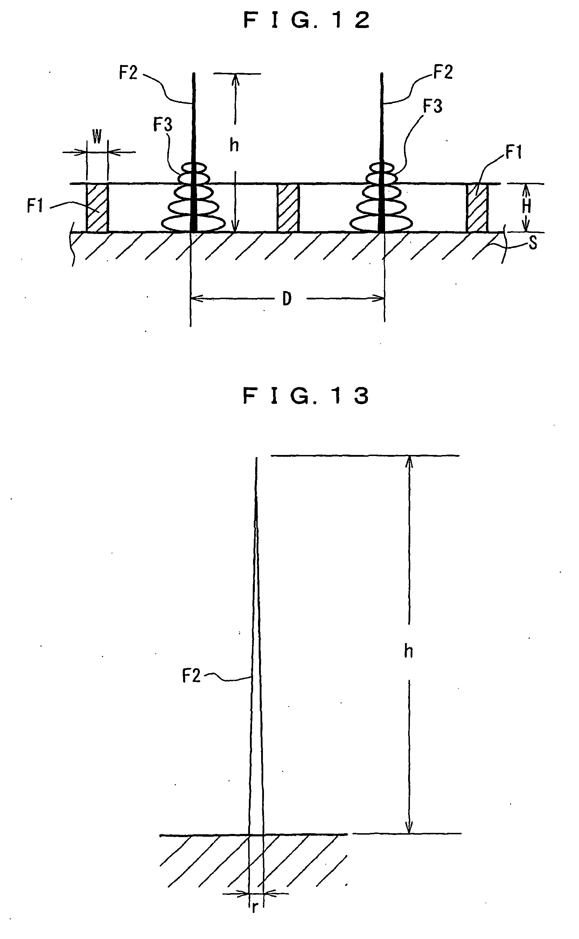

Fig. 12 is a schematic view of a structure of the carbon film shown in the SEM photographs. The conditions of the film deposition are as follows: flow amount of methane gas is 5 ccm; flow amount of hydrogen gas is 300 ccm; direct-current power is 3,000 W; high-frequency power is 500 W; temperature of conductive wire 22 is 750°C; pressure of chamber 12 is 2,000 Pa; bias is -120 V; and deposition time is 10 minutes.

The carbon film comprises a net-shape carbon film F1, one or a plurality of needle-shape carbon films F2 surrounded by the net-shape carbon film F1, and a wall-shape carbon film F3 formed in such a manner that the film gets entangled along the net-shape carbon film F2 from a lower part to an intermediate position thereof. The needle-shape carbon film F2 has such a shape that its radius is reduced from an arbitrary position towards an edge thereof.

More specifically, in the needle-shape carbon film F2, an electric field concentration coefficient β in the formula of Fowler-Nordheim is expressed as the formula of h/r provided that a radius at the arbitrary position and a height from the arbitrary position to the edge thereof are respectively r and h. Further, the needle-shape carbon film F2 has such a shape that the radius thereof is reduced from the arbitrary position to the edge thereof.

The net-shape carbon film F1 is continuously formed on a substrate S. When observed from a plane direction, an entire shape of the film is substantially a net shape. The height (H) of the net-shape carbon film F1 is substantially at most 10 nm, and the width (W) of the net-shape carbon film F1 is approximately 4 nm through 8 nm. In the region on the substrate 2 surrounded by the net-shape carbon film F1, the needle-shape carbon film F2 extends like a needle and has its edge, in which the field is concentrated to form an electron emitting point from which the electrons are emitted. Since the needle-shape carbon film F2 is surrounded by the net-shape carbon film F1, a distance between electron emitting points is restricted or defined.

The needle-shape carbon film F2 is formed so as to have a height (h) higher than the height (H) of the net-shape carbon film F1, which is, for example, approximately 60 µm. The wall-shape carbon film F3, when observed from a side surface thereof, has such a shape that its width substantially increases toward its bottom. The shape is, for example, a tapered shape. However, the shape is not exactly a tapered shape in terms of the geometry, and the term a tapered shape is used only for easy understanding. The shape of the film is actually horizontally wide, spiral or of any other similar form. In any of the shapes, the wall-shape carbon film F3 makes a good contact with the substrate S in a large bottom area so that the needle-shape carbon film F2 can be mechanically firmly supported with respect to the substrate S and an electrical contact of the needle-shape carbon film F2 with respect to the substrate S can be sufficiently obtained.

In the case of the carbon film according to the present preferred embodiment thus constituted, though an aspect ratio of the needle-shape carbon film F2 is large as carbon nanotube, the wall-shape carbon film F3 is formed so as to extend and get entangled like a wall along the needle-shape carbon film F2 from the lower part to the intermediate position thereof. Therefore, the needle-shape carbon film F2 can be mechanically firmly supported with respect to the substrate S, and is resistant to falling down on the substrate S. As a result, a stability can be improved as an electron emitting source of an illumination lamp, and an electron emitting characteristic of the illumination lamp required as the electron emitting source of the illumination lamp can be obtained because the electrical contact with respect to the substrate for supplying the current can be made by the wall-shape carbon film F3 though the diameter of the needle-shape carbon film F2 is thin.

Further, in the carbon film, a potential surface around the edge of the needle-shape carbon film F2 drastically changes, and the field is thereby intensely concentrate, while the field concentration does not occur in the net-shape carbon film F1. Further, a needle-shape carbon film F2 is separted from an adjacent needle-shape carbon film F2 by the net-shape carbon film F1 by an appropriate space (D), for example, approximately 100 µm, so that the field concentration effects of the respective films do not interfere with each other. Because the needle-shape carbon film F2 is not formed as closely as the conventional carbon nanotube, the gathering of needle-shape carbon films F2 has only a little effect on their field concentration at every net-shape carbon film F1.

In the carbon film structure according to the present preferred embodiment, the field is likely to be concentrated in the needle-shape carbon film F2. Then, the needle-shape carbon film F2 is surrounded by the net-shape carbon film F1 formed on the substrate S, which restricts the space between the needle-shape carbon films F2. Accordingly, the problem that a large number of needle-shape carbon films F2 are closely formed can be circumvented, and full use can be made of performance of the field concentration of each needle-shape carbon film F2. As a result, superir electron emitting characteristic can be provided.

The electrons can be stably emitted because the position of the needle-shape carbon film F2 on the substrate S is remarkably stabilized by the wall-shape carbon film F3. Further, directions in which the plurality of needle-shape carbon films are formed can be easily aligned. Accordingly, the electrons can be evenly emitted from the plurality of needle-shape carbon films F2 across the entire substrate. When the needle-shape carbon film F2 is used in the field emission illumination lamp as the cathode electron source, therefore, the phosphors inside the lamp can emit light with an even brightness. Further, since the needle-shape carbon film F2 is mechanically firmly supported by the wall-shape carbon film F3 with respect to the substrate S, the film F2 is unlikely to fall down on the substrate S. As a result, the stability as the electron emitting source of the illumination lamp can be improved. Further, the electrical contact of the needle-shape carbon film F2 with respect to the substrate for supplying the current can be made by the wall-shape carbon film F3.

The needle-shape carbon film F2 has such a needle shape that the electric field concentration coefficient β is expressed as the formula of h/r provided that the radius at the arbitrary position and the height from the arbitrary position to the edge thereof are respectively r and h, and the radius is reduced toward the edge. Thus, the needle-shape carbon film F2 is such a carbon film that the field emission becomes hardly saturated.

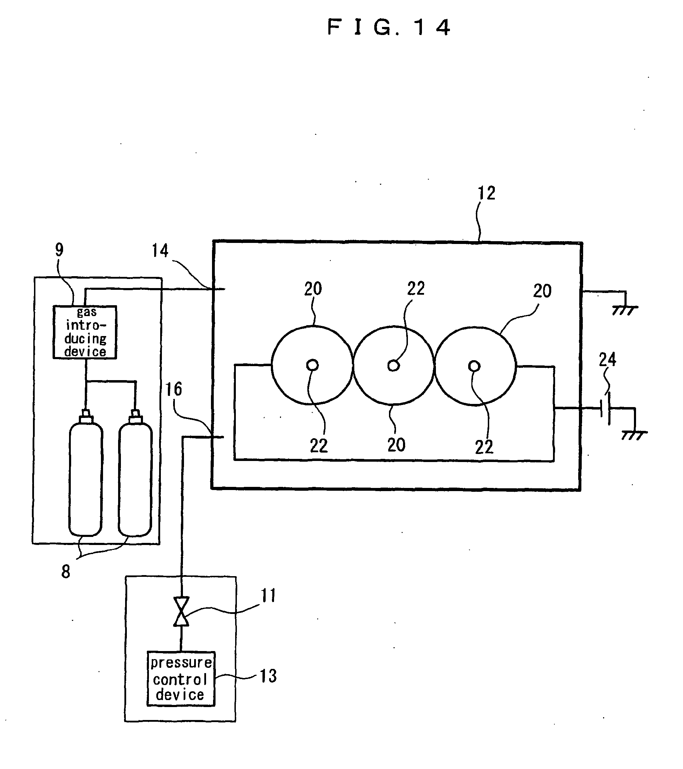

Fig. 14 shows still another example of the plasma generating device. The plasma generating device is incorporated in a film deposition device. The film deposition device is adapted to introduce gas for generating plasma from the gas cylinder 8 into the chamber 12 via the introducing section 14 after the pressure and flow amount of the gas are adjusted by a pressure / flow amount adjusting circuit 9.

The vacuum exhaust system 13 is connected to the exhausting section 14 of the chamber 12 via the exhaust control valve 11 so that the internal pressure of the chamber 12 is adjusted. The pressure inside the chamber 12 is controlled depending on the opening degree of the exhaust control valve 11 under the control by the vacuum exhaust system 13.

In the chamber 12, the cylindrical electrodes 20 are provided adjacent to one another so that outer peripheral surfaces thereof are in electrical contact with one another. These cylindrical electrodes 20 are formed from a metal net (mesh) wound in a cylindrical shape. The conductive wire 22, which is an example of the film deposition target, is placed inside each of the cylindrical electrodes 20.

The negative potential of the direct-current power source for exciting the plasma is applied to the cylindrical electrodes 20. The positive electrode of the direct-current power supply 24 is grounded, and the chamber 12 is grounded. The direct-current power supply 24 can be variably adjusted, in the voltage range of, for example, 100 - 2,000 V.

In the film deposition device thus constituted, when the internal pressure of the chamber 12 is reduced in the foregoing pressure range so that the gas is introduced from the gas introducing section 14, and the negative potential of the direct-current power supply 24 is applied to the cylindrical electrodes 20, plasma is generated in the inside of each of the cylindrical electrodes 20, which dissolves the gas. As a result, the film is formed on the surface of the conductive wire 22.

As described, in the present plasma generating device, wherein the plurality of cylindrical electrodes are provided adjacent to one another, the plasma can be sealed into the inside of each of the cylindrical electrodes with an evenly high density without any leakage.

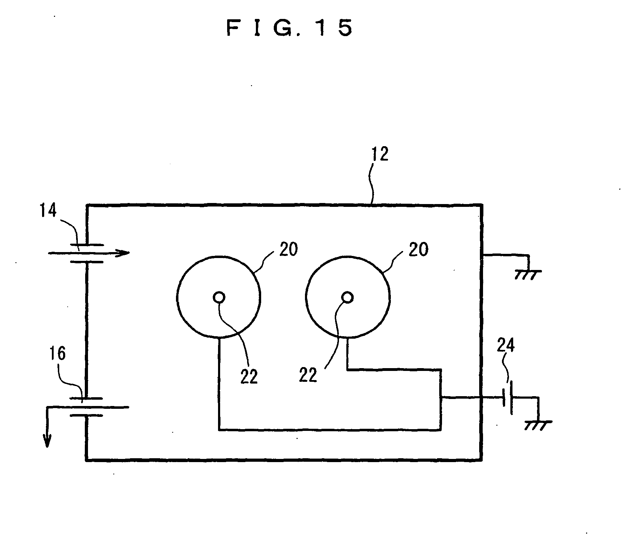

In the plurality of cylindrical electrodes 20, even in the case where they are distant from each other as shown in Fig. 15, the plasma can be generated in the inside of each of the cylindrical electrodes 20 when the same negative voltage is applied thereto from the direct-current power supply 24.

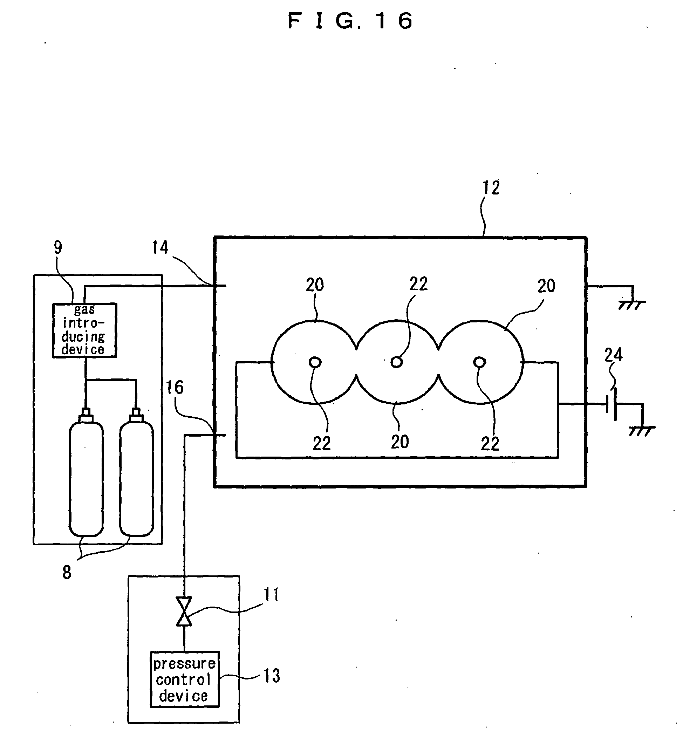

The plurality of cylindrical electrodes 20 shown in Fig. 14 are provided adjacent to one another in such an independent manner that internal parts thereof are separated from one another. According to the present invention, the plurality of cylindrical electrodes 20 are provided adjacent to one another in a continuous manner as shown in Fig. 16.

The sectional surface of the cylindrical electrode 20 may be circular, polygonal, elliptical or of any other shape. A large number of cylindrical electrodes 20 may be provided in the chamber.

In the plasma generating device so far described, wherein the conductive wire 22, for example, is provided in the inside of each of the cylindrical electrodes 20, the plasma is generated in each of the cylindrical electrodes 20, and the gas is introduced thereinto, so that a film having an even thickness and a high quality can be formed on the entire surfaces of the conductive wires 22. As a result, the present invention can contribute to the mass production of any product in which the conductive wire 22 can be used.

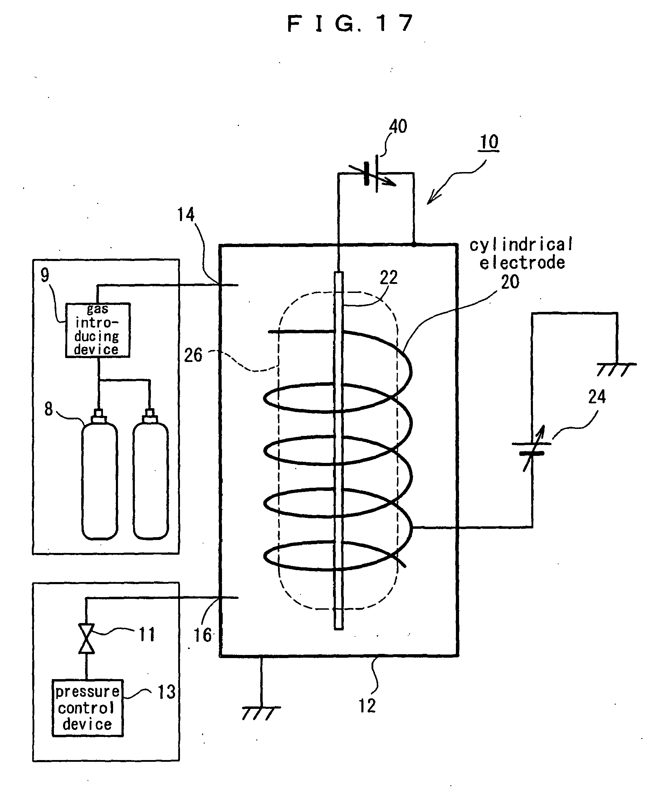

Fig. 17 shows still another example of the plasma generating device 10 according to a further aspect of the present invention; provided with a bias power supply 40. A negative electrode of the bias power supply 40 is connected to the conductive wire 22 as the film deposition target, while a positive electrode thereof is connected to the chamber 12 and grounded.

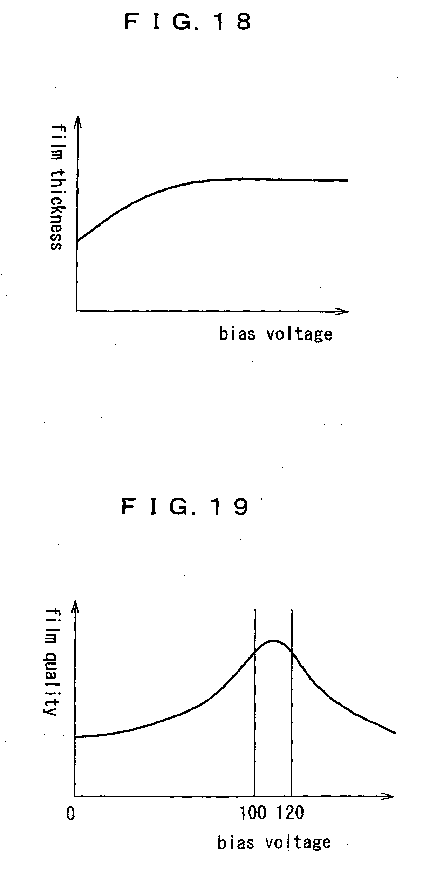

Fig. 18 is a graph in which a voltage of the bias power supply 40 is shown in a horizontal axis and a speed at which a film is deposited on the surface of the conductive wire 22 is shown in a vertical axis. As shown in Fig. 18, as the voltage of the bias power supply 40 is increased, the speed at which the film is deposited on the surface of the conductive wire 22 can be increased.

Fig. 19 is a graph in which the voltage of the bias power supply 40 is shown in a horizontal axis and a quality of the film deposited on the surface of the conductive wire 22 is shown in a vertical axis. As shown in Fig. 19, when the voltage of the bias power supply 4 is adjusted to stay in the range of, for example, 100 - 200 V, the film quality can be improved.

### INDUSTRIAL APPLICABILITY

The plasma generating device according to the present invention can generate plasma having a long length on a long film deposition target, and perform different types of film deposition by controlling pressure and selecting a type of gas.

## Claims

1. A plasma generating device comprising:
- a chamber (12),
- a cylindrical electrode (20) provided inside the chamber (12) and having an internal space, in which a conductive wire (22) being a film deposition target is provided,
- a gas introducing device (9) capable of selecting gas corresponding to a type of film deposition and of introducing the selected gas into the cylindrical electrode (20),
- a pressure control device (13) capable of controlling an internal pressure within the chamber (12) depending on a type of film deposition,
- a power supply (24) for applying a direct-current negative voltage to the cylindrical electrode (20) as a plasma generating voltage, and
- a bias power supply (40) being adapted to apply a bias voltage between the conductive wire (22) and the chamber (12),
wherein the plasma generating device is adapted to perform a plasma CVD process for forming a carbon film comprising a plurality of fine protrusions on the surface of the conductive wire (22) through the introduction of gas for carbon film deposition and high-pressure control,
wherein a plurality of said cylindrical electrodes (20) are provided adjacent to one an other in a continuous/ manner.

2. The plasma generating device as claimed in claim 1, wherein the cylindrical electrodes (20) comprise a peripheral wall whose shape is at least a coil shape, a net shape, a barrier shape or a basket shape.

3. The plasma generating device as claimed in claim 1, wherein the cylindrical electrodes (20) are open at each end and linearly extend toward both ends in accordance with the conductive wire (22).

4. The plasma generating device as claimed in claim 1, wherein a voltage in which a high-frequency voltage is superposed on the direct-current negative voltage is applied to the cylindrical electrodes (20).

5. A method for manufacturing a cold cathode electron source of a field emission lamp using a plasma generating device according to one of the preceding claims, the method comprising the following steps:
(a) placing a conductive wire (22) in the internal space of a cylindrical electrode (20) in such a way that an inner periphery surface of the cylindrical electrode (20) and an outer periphery surface of the conductive wire (22) face each other with a predetermined space therebetween in the direction they are extended;
(b) reducing an internal pressure within the chamber (12) and thus within the cylindrical electrode (20);
(c) introducing gas for carbon film deposition into the cylindrical electrode (20);
(d) applying direct-current negative voltage to the cylindrical electrode (20) to generate a plasma in the internal space of the cylindrical electrode (20);
(e) applying a bias voltage between the conductive wire (22) and the chamber (12); and
(f) performing a plasma CVD process for forming a carbon film comprising a plurality of fine protrusions on the surface of the conductive wire (22) through the introduction of gas for carbon film deposition and high-pressure control.

6. The plasma generating method as claimed in claim 5, wherein a high-frequency voltage is superposed on the direct-current negative voltage in step (d).

7. The plasma generating method as claimed in claim 5, further comprising a step for placing the conductive wire (22) inside the cylindrical electrode and heating the conductive wire (22) by an alternate-current power supply.

## Patentansprüche

1. Plasmaerzeugungsvorrichtung, die umfasst:
- eine Kammer (12),
- eine zylindrische Elektrode (20), die in der Kammer (12) vorgesehen ist und einen Innenraum besitzt, in dem ein leitender Draht (22), der ein Filmablagerungs-Target ist, vorgesehen ist;
- eine Gaseinleitungsvorrichtung (9), die Gas, das einem Typ einer Filmablagerung entspricht, auswählen kann und das ausgewählte Gas in die zylindrische Elektrode (20) einleiten kann,
- eine Drucksteuervorrichtung (13), die einen Innendruck in der Kammer (12) in Abhängigkeit von einem Typ einer Filmablagerung steuern kann,
- eine Leistungsversorgung (24), um an die zylindrische Elektrode (20) eine negative Gleichspannung als eine Plasmaerzeugungsspannung anzulegen, und
- eine Vorspannungsleistungsquelle (40), die dafür ausgelegt ist, zwischen dem leitenden Draht (22) und der Kammer (12) eine Vorspannung anzulegen,
wobei die Plasmaerzeugungsvorrichtung dafür ausgelegt ist, einen Plasma-CVD-Prozess auszuführen, um durch das Einleiten von Gas für eine Kohlenstofffilmablagerung und durch Hochdrucksteuerung einen Kohlenstofffilm zu bilden, der auf der Oberfläche des leitenden Drahts (22) mehrere feine Vorsprünge besitzt,
wobei mehrere der zylindrischen Elektroden (20) nebeneinander auf kontinuierliche Weise vorgesehen sind.

2. Plasmaerzeugungsvorrichtung nach Anspruch 1, wobei die zylindrischen Elektroden (20) eine Umfangswand aufweisen, deren Form spulenförmig und/oder netzförmig und/oder barrierenförmig und/ oder korbförmig ist.

3. Plasmaerzeugungsvorrichtung nach Anspruch 1, wobei die zylindrischen Elektroden (20) an jedem Ende offen sind und sich zu beiden Enden entsprechend dem leitenden Draht (22) geradlinig erstrecken.

4. Plasmaerzeugungsvorrichtung nach Anspruch 1, wobei an die zylindrischen Elektroden (20) eine Spannung, bei der der negativen Gleichspannung eine Hochfrequenzspannung überlagert ist, angelegt wird.

5. Verfahren zum Herstellen einer Kaltkatoden-Elektronenquelle einer Feldemissionslampe unter Verwendung einer Plasmaerzeugungsvorrichtung nach einem der vorhergehenden Ansprüche, wobei das Verfahren die folgenden Schritte umfasst:
(a) Anordnen eines leitenden Drahts (22) im Innenraum einer zylindrischen Elektrode (20), derart, dass eine innere Umfangsoberfläche der zylindrischen Elektrode (20) und eine äußere Umfangsoberfläche des leitenden Drahts (22) einander zugewandt sind, wobei in der Richtung, in der sie sich erstrecken, ein vorgegebener Zwischenraum vorhanden ist;
(b) Verringern eines Innendrucks in der Kammer (12) und daher in der zylindrischen Elektrode 20);
(c) Einleiten von Gas für eine Kohlenstofffilmablagerung in die zylindrische Elektrode (20);
(d) Anlegen einer negativen Gleichspannung an die zylindrische Elektrode (20), um in dem Innenraum der zylindrischen Elektrode ein Plasma zu erzeugen;
(e) Anlegen einer Vorspannung zwischen dem leitenden Draht (22) und der Kammer (12); und
(f) Ausführen eines Plasma-CVD-Prozesses, um durch das Einleiten von Gas für die Kohlenstofffilmablagerung und durch Hochdrucksteuerung einen Kohlenstofffilm zu bilden, der auf der Oberfläche des leitenden Drahts (22) mehrere feine Vorsprünge aufweist.

6. Plasmaerzeugungsverfahren nach Anspruch 5, wobei im Schritt (d) der negativen Gleichspannung eine Hochfrequenzspannung überlagert wird.

7. Plasmaerzeugungsverfahren nach Anspruch 5, das ferner einen Schritt zum Anordnen des leitenden Drahts (22) in der zylindrischen Elektrode und des Erhitzens des leitenden Drahts (22) durch eine Wechselstrom-Leistungsversorgung umfasst.

## Revendications

1. Dispositif de génération de plasma, comprenant :
- une chambre (12),
- une électrode cylindrique (20) prévue à l'intérieur de la chambre (12) et ayant un espace interne dans lequel est prévu un fil conducteur (22) qui est une cible de déposition de film,
- un dispositif d'introduction de gaz (9) capable de sélectionner un gaz correspondant à un type de déposition de film et d'introduire le gaz sélectionné dans l'électrode cylindrique (20),
- un dispositif de commande de pression (13) capable de commander une pression interne dans la chambre (12) en dépendance d'un type de déposition de film,
- une alimentation de puissance (24) pour appliquer un voltage négatif en courant continu à l'électrode cylindrique (20) à titre de voltage de génération de plasma, et
- une alimentation de puissance de polarisation (40) qui est adaptée à appliquer un voltage de polarisation entre le fil conducteur (22) et la chambre (12),
dans lequel le dispositif de génération de plasma est adapté à exécuter un processus de déposition chimique en phase vapeur (CVD) sous plasma pour former un film de carbone comprenant une pluralité de fines projections sur la surface du fil conducteur (22) par l'introduction de gaz pour la déposition du film de carbone et la commande de haute pression,
dans lequel une pluralité desdites électrodes cylindriques (20) sont prévues adjacentes les unes aux autres d'une manière continue.

2. Dispositif de génération de plasma selon la revendication 1, dans lequel les électrodes cylindriques (20) comprennent une paroi périphérique dont la forme est au moins une forme en bobine, une forme en filet, une forme en barrière ou une forme en panier.

3. Dispositif de génération de plasma selon la revendication 1, dans lequel les électrodes cylindriques (20) sont ouvertes à chaque extrémité et s'étendent de manière linéaire vers les deux extrémités en accord avec le fil conducteur (22).

4. Dispositif de génération de plasma selon la revendication 1, dans lequel un voltage dans lequel un voltage à haute fréquence est superposé sur le voltage négatif en courant continu est appliqué aux électrodes cylindriques (20).

5. Procédé pour fabriquer une source d'électrons à cathode froide d'une lampe à émission de champ en utilisant un dispositif de génération de plasma selon l'une des revendications précédentes, le procédé comprenant les étapes suivantes :
(a) on place un fil conducteur (22) dans l'espace interne d'une électrode cylindrique (20) d'une manière telle qu'une surface périphérique intérieure de l'électrode cylindrique (20) et une surface périphérique extérieure du fil conducteur (22) se font mutuellement face avec un espace prédéterminé entre elles dans la direction dans laquelle elles s'étendent ;
(b) on réduit une pression interne dans la chambre (12) et donc dans l'électrode cylindrique (20) ;
(c) on introduit un gaz pour déposition d'un film de carbone dans l'électrode cylindrique (20) ;
(d) on applique un voltage négatif en courant continu à l'électrode cylindrique (20) pour générer un plasma dans l'espace interne de l'électrode cylindrique (20) ;
(e) on applique un voltage de polarisation entre le fil conducteur (22) et la chambre (12) ; et
(f) on exécute un processus de déposition chimique en phase vapeur à plasma (CVD) pour former un film de carbone comprenant une pluralité de fines projections sur la surface du fil conducteur (22) via l'introduction de gaz pour la déposition d'un film de carbone, et la commande de haute pression.

6. Procédé de génération de plasma selon la revendication 5, dans lequel un voltage à haute fréquence est superposé sur le voltage négatif en courant continu dans l'étape (d).

7. Procédé de génération de plasma selon la revendication 5, comprenant en outre une étape consistant à placer le fil conducteur (22) à l'intérieur de l'électrode cylindrique, et à chauffer le fil conducteur (22) par alimentation de puissance en courant alternatif.
